# EUROPEAN PATENT APPLICATION

(11) **EP 4 776 284 A1**
(43) Date of publication of application: **15.07.2026**
(21) Application number: 26150506.9
(22) Date of filing: 07.01.2026
(51) Int. Cl.: G11C 7/02, G11C 7/10, G11C 29/02

(54) **CONTROLLER AND MEMORY MODULE WITH ADJUSTEMT OF INPUT/OUTPUT CIRCUITS TO REDUCE WAVEFORM DISTORTIONS IN SIGNAL TRANSMISSION**

(30) Priority: 09.01.2025 JP 2025003298
(71) Applicant: KYOCERA Document Solutions Inc., Osaka-shi, Osaka 540-8585 (JP)
(72) Inventor: MATSUMOTO, Hitoshi, Osaka, 540-8585 (JP)
(74) Representative: Winter, Brandl - Partnerschaft mbB

(57) **Abstract**

An electronic apparatus includes a controller circuit board, and an internal device configured to be controlled by the controller circuit board. Further, the controller circuit board includes a memory module and a processor configured to transmit and receive a transmission signal to/from the memory module and thereby perform read and write of data. The processor includes a first input/output circuit configured to transmit and receive the transmission signal, and the memory module includes a second input/output circuit configured to transmit and receive the transmission signal. If the read or the write is not performed properly due to waveform distortion of the transmission signal, the processor changes an output condition or an input condition of the transmission signal in at least one of the first and second input/output circuits such that the waveform distortion does not cross a level detection threshold value of the transmission signal.

## Description

### BACKGROUND

### 1. FIELD OF THE PRESENT INVENTION

The present invention relates to an electronic apparatus.

### 2. DESCRIPTION OF THE RELATED ART

An electronic apparatus includes a micro computer and a memory module, and the micro computer transmits and receives sorts of control signals and data signals to/from the memory module and thereby reads and writes data from/to the memory module.

The memory module and the processor as mentioned are installed on a controller circuit board, and if the controller circuit board is arranged together with another internal device in the electronic apparatus, waveform distortion may appear on the aforementioned control signal or data signal due to the influence of the other internal device (e.g. noise such as power supply noise) and when such waveform distortion appears, the memory module may not be controlled properly.

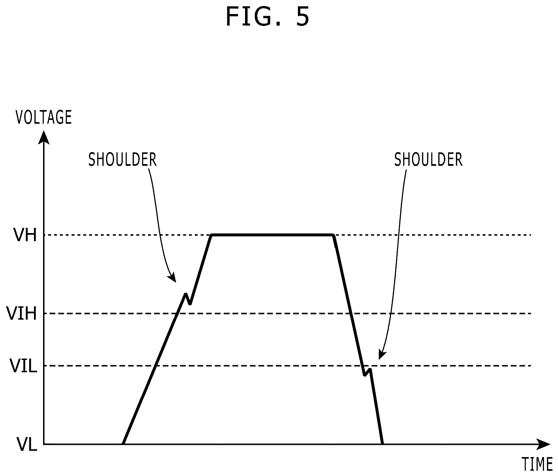

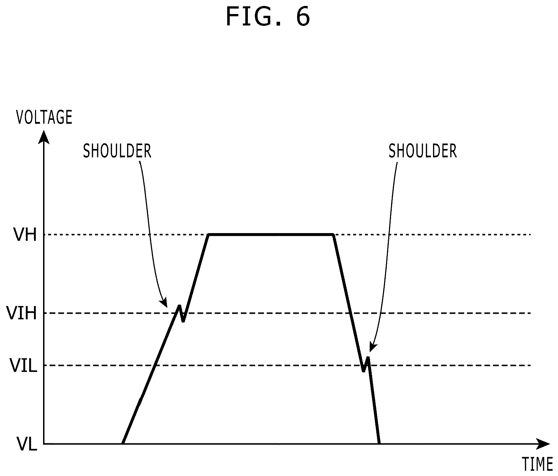

Fig. 5 shows a diagram that indicates an example of waveform distortion of a transmission signal between a memory module and a processor. Fig. 6 shows a diagram that indicates another example of waveform distortion of a transmission signal between a memory module and a processor.

Even though waveform distortion such as shoulder appears on the transmission signal, if the waveform distortion does not cross either a threshold value VIH for high-level detection of the transmission signal or a threshold value VIL for low-level detection of the transmission signal as shown in Fig. 5 for example, then misdetection of its signal level does not occur due to the waveform distortion. However, as shown in Fig. 6, for example, if the waveform distortion does not cross the threshold value VIH or the threshold value VIL, then misdetection of its signal level may occur due to the waveform distortion.

### SUMMARY

An electronic apparatus according to the present invention includes a controller circuit board; and an internal device. The internal device is configured to be controlled by the controller circuit board. Further, the controller circuit board includes a memory module and a processor configured to transmit and receive a transmission signal to/from the memory module and thereby perform read and write of data. The processor includes a first input/output circuit configured to transmit and receive the transmission signal, and the memory module includes a second input/output circuit configured to transmit and receive the transmission signal. If the read or the write is not performed properly due to waveform distortion of the transmission signal, the processor changes an output condition or an input condition of the transmission signal in at least one of the first and second input/output circuits such that the waveform distortion does not cross a level detection threshold value of the transmission signal.

These and other objects, features and advantages of the present invention will become more apparent upon reading of the following detailed description along with the accompanied drawings.

### BRIEF DESCRIPTION OF THE DRAWINGS

Fig. 1 shows a block diagram that indicates a configuration of an electronic apparatus according to an embodiment of the present invention;
Fig. 2 shows a diagram that explains a waveform of a transmission signal between a processor 21 and a memory module 22;
Fig. 3 shows a diagram that explains a waveform after changing an input condition or an output condition;
Fig. 4 shows a diagram that explains level detection threshold values after changing;
Fig. 5 shows a diagram that indicates an example of waveform distortion of a transmission signal between a memory module and a processor; and
Fig. 6 shows a diagram that indicates another example of waveform distortion of a transmission signal between a memory module and a processor.

### DETAILED DESCRIPTION

Hereinafter, an embodiment according to an aspect of the present invention will be explained with reference to drawings.

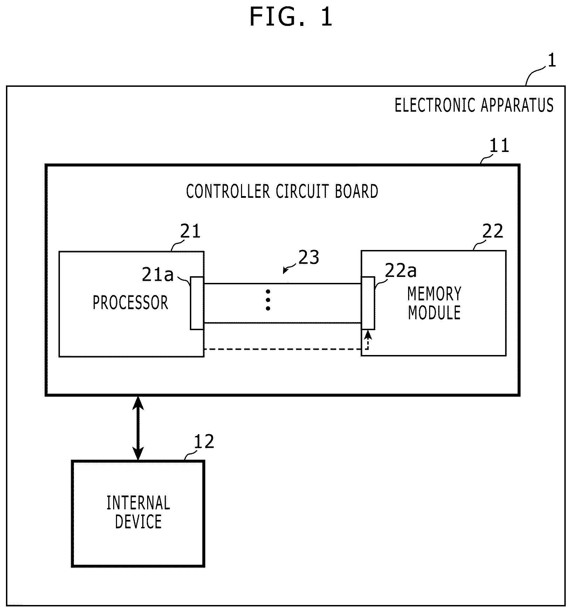

Fig. 1 shows a block diagram that indicates a configuration of an electronic apparatus according to an embodiment of the present invention. The electronic apparatus 1 shown in Fig. 1 is an image forming apparatus such as multi function peripheral, and includes a controller circuit board 11 and an internal device 12.

The controller circuit board 11 controls the internal device 12. The internal device 12 is a device that provides a specific function. For example, if the electronic apparatus 1 is an image forming apparatus, the internal device 12 is a printing device, a scanner device, a communication device, an operation panel, a power supply device, and/or the like.

The controller circuit board 11 includes a processor 21, a memory module 22, and a signal line 23 between the processor 21 and the memory module 22, and the processor 21 includes a CPU (Central Processing Unit), an ASIC (Application Specific Integrated Circuit) and/or the like.

The processor 21 executes a predetermined program, and in accordance with the program, performs read and write of data from/to the memory module 22 and performs a predetermined data process and control of the internal device 12. Specifically, the processor 21 transmits and receives a transmission signal through the signal line 23 to/from the memory module 22 and thereby performs read and write of data.

The processor 21 includes a memory controller, and the memory controller includes an input/output circuit 21a. The input/output circuit 21a transmits and receives a transmission signal (a data signal, a control signal such as address signal, and the like) to/from the memory module 22.

The memory module 22 is a dynamic RAM (Random Access Memory) as a main memory, and is a DDR-SDRAM (Double Data Rate - Synchronous Dynamic RAM), for example. The memory module 22 includes a second input/output circuit 22a that transmits and receives a transmission signal.

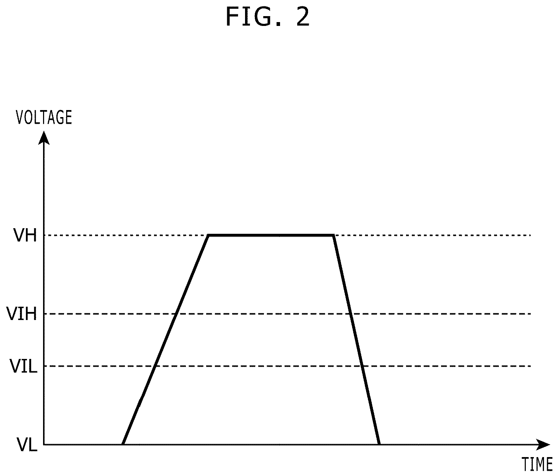

Fig. 2 shows a diagram that explains a waveform of a transmission signal between the processor 21 and the memory module 22. In a normal status, as shown in Fig. 2, for example, waveform distortion does not appear on the transmission signal in the controller circuit board 11. However, such controller circuit boards 11 are used in plural types of electronic apparatuses 1, and affected by noise or the like corresponding to layouts, specifications or the like of the internal devices 12 in the electronic apparatuses 1. Therefore, as shown Figs. 5 and 6, for example, waveform distortion due to an external environment appears on the transmission signal. Further, as shown in Fig. 6, for example, if the waveform distortion crosses a level detection threshold value VIH or VIL, level detection of the transmission signal as a digital signal (i.e. binary signal) is not performed properly, and consequently, the read or the write is not performed properly.

Therefore, if the read or the write is not performed properly due to waveform distortion of the transmission signal, the processor 21 changes an output condition or an input condition of the transmission signal in at least one of the first and second input/output circuits 21a and 22a such that the waveform distortion does not cross the level detection threshold value VIH or VIL of the transmission signal. Specifically, changed is/are only one or both among (a) an output condition of an output side (transmitter side) of the transmission signal among the input/output circuits 21a and 22a and (b) an input condition of an input side (receiver side) of the transmission signal among the input/output circuits 21a and 22a.

Specifically, in a normal status, the transmission signal crosses the level detection threshold value VIH or VIL only once at rising (VIL to VIH) or falling (VIH to VIL) of the transmission signal, but in an abnormal status, since waveform a distortion component is added on the transmission signal, the transmission signal crosses the level detection threshold value VIH or VIL plural times at rising or falling of the transmission signal as shown in Fig. 5, for example. Therefore, changing one or both of the input condition and the output condition of the transmission signal restrains that the transmission signal crosses the level detection threshold value VIH or VIL plural times at rising or falling of the transmission signal.

It should be noted that in advance it is confirmed that the controller circuit board 11 properly performs (i.e. properly performs read and write) when the controller circuit board 11 operates alone, but if the controller circuit board 11 installed in the electronic apparatus 1 does not perform read and write properly, then it is determined that the read or the write is not properly performed due to waveform distortion of the transmission signal.

Specifically, for example, the aforementioned output condition to be changed is an output drive capability of an output side (transmitter side) of the transmission signal among the first and second input/output circuits 21a and 22a; and if the read or the write is not performed properly due to waveform distortion of the transmission signal, the processor 21 gains the output drive capability.

Specifically, an output part in the input/output circuit 21a and 22a includes plural output circuits that have different output drive capabilities from each other, and the processor 21 changes an output circuit to be used to output the transmission signal among the plural output circuits in a software manner (i.e. in accordance with the aforementioned program), and thereby changes the output drive capability.

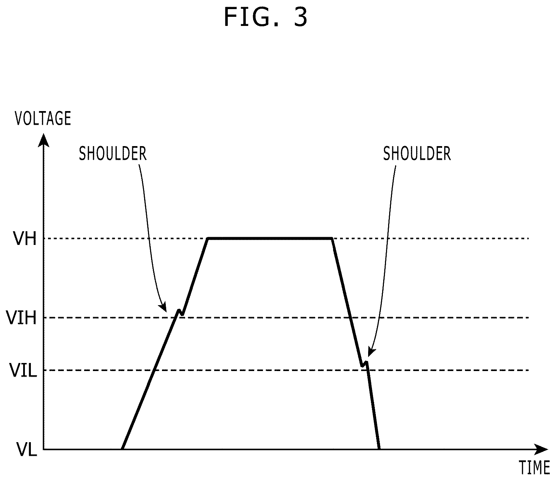

Fig. 3 shows a diagram that explains a waveform after changing an input condition or an output condition.

For example, the aforementioned plural output circuits output different output currents from each other, and the processor 21 switches the output circuit and increases the output current and thereby gains the output drive capability. Consequently, an amplitude of a waveform distortion component added on the transmission signal becomes small as shown in Fig. 3, for example, and the waveform distortion disappears as shown in Fig. 2, and therefore, the transmission signal does not cross the level detection threshold value VIH or VIL plural times.

Alternatively, plural output circuits having different throughputs may be installed and the processor 21 may switch an output circuit that outputs the transmission signal among the plural output circuits and change the throughput and thereby gain the output drive capability.

Further, for example, the aforementioned input condition to be changed includes a terminal resistance value of an input side (receiver side) of the transmission signal among the input/output circuits 21a and 22a, and if the read or the write is not performed properly due to waveform distortion of the transmission signal, the processor 21 decreases the terminal resistance value. The terminal resistance value is a resistance value of an ODT (On Die Termination), for example.

Specifically, an input part in the input/output circuit 21a and 22a includes plural input circuits that have different terminal resistance values from each other, and the processor 21 changes an input circuit to be used to input the transmission signal among the plural input circuits in a software manner (i.e. in accordance with the aforementioned program), and thereby changes the terminal resistance value. Consequently, an amplitude of a waveform distortion component added on the transmission signal becomes small as shown in Fig. 3, for example, and the waveform distortion disappears as shown in Fig. 2, and therefore, the transmission signal does not cross the level detection threshold value VIH or VIL plural times.

Further, the aforementioned input condition includes the level detection threshold value(s) VIH and/or VIL of an input side of the transmission signal among the input/output circuits 21a and 22a.

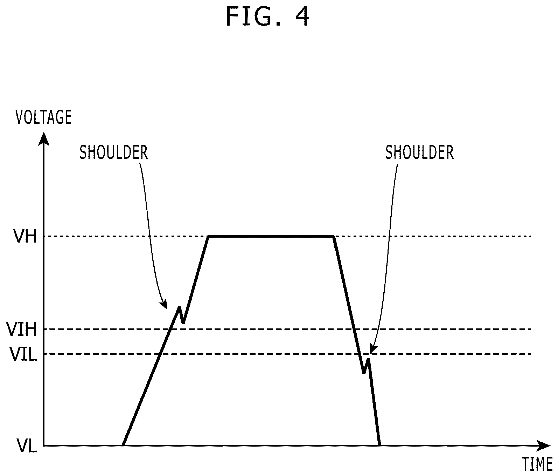

Fig. 4 shows a diagram that explains level detection threshold values after changing. If the read or the write is not performed properly due to waveform distortion of the transmission signal, the processor 21 changes the level detection threshold value(s) VIH and/or VIL such that the waveform distortion does not cross either the level detection threshold value VIH or VIL of the transmission signal as shown in Fig. 4, for example. Specifically, the processor 21 increases or decreases the level detection threshold value VIH by a predetermined voltage width, and increases or decreases the level detection threshold value VIL by a predetermined voltage width.

The following part explains the aforementioned electronic apparatus 1.

In the controller circuit board 11, the processor 21 operates in accordance with a predetermined program, and thereby performs sorts of data processes using the memory module 22 and controls the internal device 12.

In that time, if the processor 21 detects that the read or the write from/to the memory module 22 is not performed properly, then the processor 21 changes at least one of an output condition of an output side of the transmission signal and an input condition of an input side of the transmission signal among the input/output circuits 21a and 22a, as mentioned.

It should be noted that an operator may detect it manually using a measuring instrument or the like that the read or the write from/to the memory module is not performed properly due to waveform distortion, and may input an instruction to the processor 21 through an input device or the like with a user operation or the like; and in accordance with the instruction, the processor 21 may change at least one of an output condition of an output side of the transmission signal and an input condition of an input side of the transmission signal among the input/output circuits 21a and 22a, as mentioned.

Afterward, if the processor 21 detects that the read or the write from/to the memory module 22 is not performed properly again, the processor 21 may change at least one of the output condition and the input condition again, or may perform an error process (cancellation of the operation, and notification to a user).

As mentioned, in the aforementioned embodiment, the controller circuit board 11 includes the memory module 22 and a processor 21 that transmits and receives a transmission signal to/from the memory module 22 and thereby performs read and write of data. The processor 21 includes the first input/output circuit 21a that transmits and receives the transmission signal, and the memory module 22 includes the second input/output circuit 22a that transmits and receives the transmission signal. Further, if the read or the write is not performed properly due to waveform distortion of the transmission signal, the processor 21 changes an output condition or an input condition of the transmission signal in at least one of the first and second input/output circuits 21a and 22a such that the waveform distortion does not cross either a level detection threshold value VIH or VIL of the transmission signal.

Consequently, even if waveform distortion due to an external environment appears in the controller circuit board 1, the memory module is controller properly. The output condition or the input condition of the transmission signal is changed by the processor 21, the operation is improved in a software manner without hardware improvement such as hardware design change of the controller circuit board 1 or replacement with another controller circuit board.

It should be understood that various changes and modifications to the embodiments described herein will be apparent to those skilled in the art. Such changes and modifications may be made without departing from the spirit and scope of the present subject matter and without diminishing its intended advantages. It is therefore intended that such changes and modifications be covered by the appended claims.

## Claims

1. An electronic apparatus, comprising:
a controller circuit board; and
an internal device configured to be controlled by the controller circuit board;
wherein the controller circuit board comprises a memory module, and a processor configured to transmit and receive a transmission signal to/from the memory module and thereby perform read and write of data;
the processor comprises a first input/output circuit configured to transmit and receive the transmission signal; the memory module comprises a second input/output circuit configured to transmit and receive the transmission signal; and
if the read or the write is not performed properly due to waveform distortion of the transmission signal, the processor changes an output condition or an input condition of the transmission signal in at least one of the first and second input/output circuits such that the waveform distortion does not cross a level detection threshold value of the transmission signal.

2. The electronic apparatus according to claim 1, wherein the output condition is an output drive capability of an output side of the transmission signal among the first and second input/output circuits; and
if the read or the write is not performed properly due to waveform distortion of the transmission signal, the processor gains the output drive capability.

3. The electronic apparatus according to claim 2, wherein the processor changes an output current of the transmission signal and thereby gains the output drive capability.

4. The electronic apparatus according to claim 1, wherein the input condition is a terminal resistance value of an input side of the transmission signal among the first and second input/output circuits; and
if the read or the write is not performed properly due to waveform distortion of the transmission signal, the processor decreases the terminal resistance value.

5. The electronic apparatus according to claim 1, wherein the input condition is a level detection threshold value of an input side of the transmission signal among the first and second input/output circuits; and
if the read or the write is not performed properly due to waveform distortion of the transmission signal, the processor changes the level detection threshold value such that the waveform distortion does not cross the level detection threshold value of the transmission signal.
